# EUROPEAN PATENT APPLICATION

(11) **EP 2 473 012 A1**
(43) Date of publication of application: **04.07.2012**
(21) Application number: 10197384.0
(22) Date of filing: 30.12.2010
(51) Int. Cl.: H05K 1/14, H05K 1/18

(54) **Combining printed circuit boards**

(71) Applicant: Research In Motion Limited, Waterloo, ON N2L 3W8 (CA)
(72) Inventor: Cjen, Chao, Waterloo Ontario N2L 3L3 (CA)
(74) Representative: Patel, Binesh

(57) **Abstract**

An apparatus includes a first printed circuit defining an aperture and configured for conductive communication between a first plurality of electronic components, and a second printed circuit configured for conductive communication between a second plurality of electronic components. The second printed circuit is fixed to the first printed circuit such that the second plurality of electronic components pass through the aperture, and the second plurality of electronic components are in conductive communication with the first plurality of electronic components.

## Description

The present application relates generally to electronic devices and, more specifically, to circuit boards for such devices.

As electronic manufacturers compete to differentiate their devices from devices of their competitors, many compete to achieve the lightest devices. Additionally, in the area of devices for which size and shape assist with function, rather than make devices smaller, manufacturers compete to reduce the thickness of the devices.

### GENERAL

A first printed circuit includes an aperture and components on a second printed circuit pass through the aperture. Accordingly, a gap between the first printed circuit and another component in a stack of components may be smaller in comparison to existing component stacks, thereby also allowing the depth of the stack to be smaller.

According to an aspect of the present disclosure, there is provided a apparatus comprising a first printed circuit defining an aperture and configured for conductive communication between a first plurality of electronic components, and a second printed circuit configured for conductive communication between a second plurality of electronic components, the second printed circuit fixed to the first printed circuit such that: the second plurality of electronic components pass through the aperture; and the second plurality of electronic components are in conductive communication with the first plurality of electronic components.

According to an aspect of the present disclosure, there is provided a method of manufacturing an apparatus. The method comprises forming an aperture in a first printed circuit configured for conductive communication between a first plurality of electronic components and fixing a second printed circuit configured for conductive communication between a second plurality of electronic components to the first printed circuit such that: the second plurality of electronic components pass through the aperture; and the second plurality of electronic components are in conductive communication with the first plurality of electronic components.

Other aspects and features of the present disclosure will become apparent to those of ordinary skill in the art upon review of the following description of specific implementations of the disclosure in conjunction with the accompanying figures.

### BRIEF DESCRIPTION OF THE DRAWINGS

Reference will now be made, by way of example, to the accompanying drawings, which show example implementations, in which:

FIG. 1 illustrates a cross-section of a first generic electronic device having a rigid printed circuit board;

FIG. 2 illustrates a cross-section of a second generic electronic device, according to an implementation of the present application;

FIG. 3 illustrates a third generic electronic device according to an implementation of the present application; and

FIG. 4 illustrates a fourth generic electronic device according to an implementation of the present application.

### DESCRIPTION OF PREFERRED EMBODIMENTS

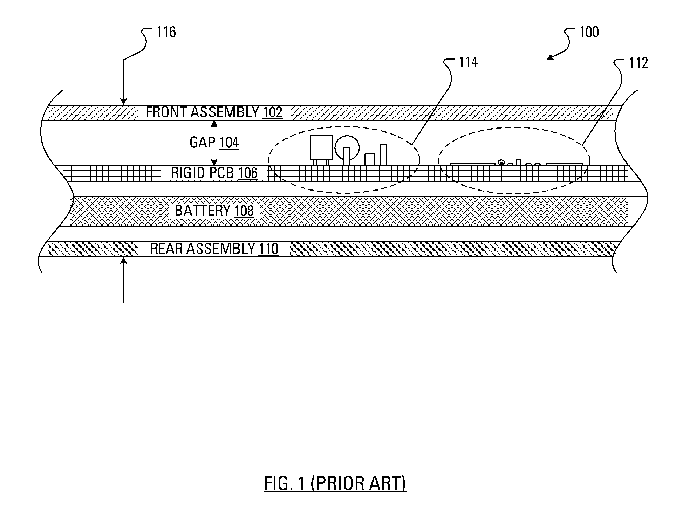

FIG. 1 illustrates a cross-section of a first prior art generic electronic device 100. Elements of the first generic electronic device 100 are arranged in a stack. From arbitrary top to bottom, the first generic electronic device 100 includes a front assembly 102, a rigid printed circuit board (PCB) 106, a battery 108 and a rear assembly 110. It is typical that the rigid PCB 106 includes electronic components such as integrated circuits, capacitors, resistors and inductor coils, among other components that will be equally familiar to those of ordinary skill in the art. Some of the components may be considered together as "low profile" or a first plurality of components and are associated in FIG. 1 with reference numeral 112. Some of the components may be considered together as "high profile" or a second plurality of components and are associated in FIG. 1 with reference numeral 114. In manufacturing of the first generic electronic device 100, a first gap 104 is established between the front assembly 102 and the rigid PCB 106. In particular, the first gap 104 may be established to accommodate the height of the high profile components 114.

The first generic electronic device 100 may be characterized in descriptive literature as having a first depth, or thickness, 116.

In overview, it is proposed herein to fix the high profile components 114 to a flexible PCB (hereinafter "FPC") and combine the flexible PCB with a rigid PCB defining an aperture. By connecting the FPC to the rigid PCB such that the high profile components 114 pass through the aperture, the gap 104 between the front assembly 102 and the rigid PCB 106 may be reduced. Conveniently, a reduction in the gap 104 between the front assembly 102 and the rigid PCB 106 may be used to reduce the depth of the generic electronic device. Furthermore, an electronic device with a reduced depth may be associated with a lower material cost because the material required for the housing to encase the electronic components is reduced. Advantageously, when the overall size of the electronic device is reduced by reducing its depth, ease of portability of the electronic device is increased and the chance of contaminants entering the device may be reduced.

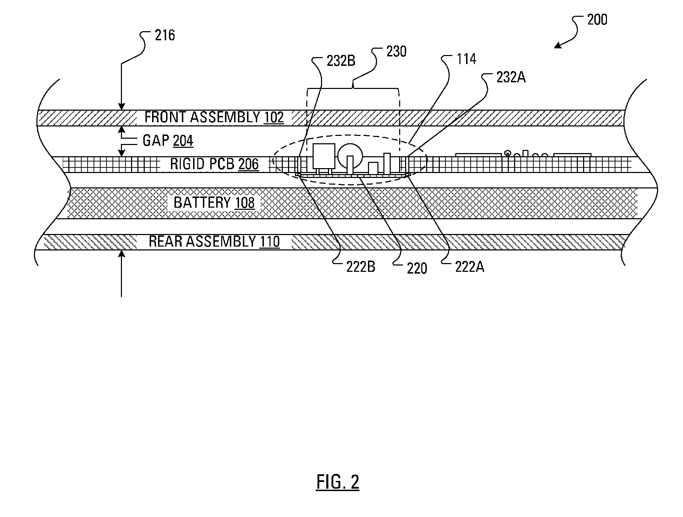

FIG. 2 illustrates a cross-section of a second generic electronic device 200 in accordance with the present disclosure. The second generic electronic device 200 includes the front assembly 102, the battery 108 and the rear assembly 110 familiar from the first generic electronic device 100 of FIG. 1. Distinctly, the second generic electronic device 200 of FIG. 2 includes a first printed circuit 206, which may be considered an adapted PCB 206. The adapted PCB 206 may be similar to the rigid PCB 106 of FIG. 1, except that the adapted PCB 206 defines an aperture 230. The aperture 230 is a through hole, which may be formed using a routing process. While the position of the aperture 230 is left as an implementation detail, in one embodiment, the aperture 230 is positioned behind a portion of the front assembly 102 that includes a display for the electronic device.

The high profile components 114 are conductively fixed to a second printed circuit 220. As illustrated, the second printed circuit 220 is a flexible printed circuit (FPC) 220 that is conductively fixed to the adapted PCB 206 via contacts (not shown) provided around the periphery of the aperture 230. The high profile components 114 are arranged on the FPC 220 so as to pass through the aperture 230 when the FPC 220 is conductively fixed (e.g., using solder) to the adapted PCB 206.

The second generic electronic device 200 may be characterized in descriptive literature as having a second depth, or thickness, 216.

In manufacturing of the second generic electronic device 200, a second gap 204 is established between the front assembly 102 and the adapted PCB 206. In particular, the second gap 204 may be established to accommodate the height of the high profile components 114. However, since the high profile components 114 are arranged to pass through the aperture 230 in the adapted PCB 206, the second gap 204 of FIG. 2 need not be as large as the first gap 104 of FIG. 1. Accordingly, the second depth 216 of FIG. 2 need not be as large as the first depth 116 of FIG. 1. That is, when using the high profile components 114, the second gap 204 may be approximately 1 mm smaller than the first gap 104.

Alternatively, rather than allowing the second gap 204 to be smaller than the first gap 104, while accommodating the high profile components 114 that are illustrated in FIGS. 1 and 2, one can consider the combination of the adapted PCB 206 and the FPC 220 to allow the second gap 204 to have a dimension similar to the first gap 104 such that high profile components that are taller than the illustrated high profile components 114 may be accommodated.

In some known electronic devices, the first gap 104 between the front assembly 102 and the PCB 106 is in the range of 0.8 mm to 1.2 mm. Given that a typical rigid PCB has a 1 mm thickness, there is potential for the second gap 204 to be 1 mm smaller than the first gap 104, i.e., 0 mm to 0.2 mm. Alternatively, the size of the second gap 204 may be the same as the size of the first gap 104 and the second generic electronic device 200 could include components (not shown) that are 1 mm taller than the high profile components 114.

Occasionally, it may be useful to provide the high profile components 114 with a so-called "shielding can". A shielding can may, for example, be used to reduce electromagnetic interference (EMI). The EMI may be radio frequency interference (RF) originating at the high profile components 114, in which case the shielding can reduce EMI with components outside of the shielding can. Alternatively, the EMI may originate with components outside of the shielding can, in which case the shielding can reduce the effect EMI may have on the high profile components 114.

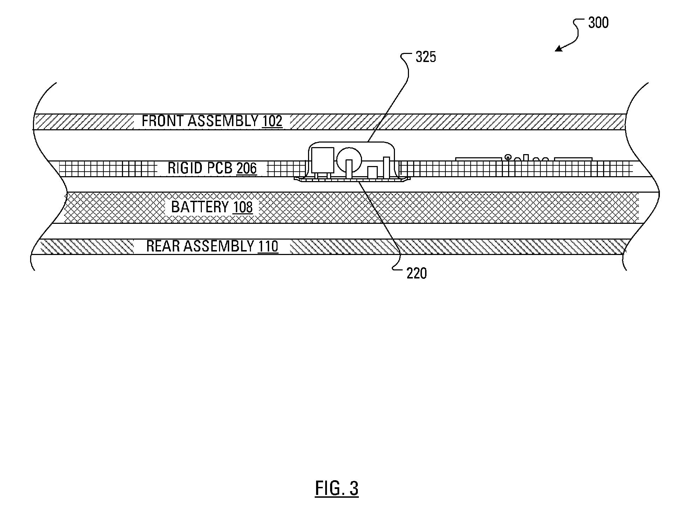

FIG. 3 illustrates one implementation in accordance with the present disclosure, referenced as a third generic electronic device 300, wherein a first shielding can 325 has been added to the electronic device 300 in a manner such that the first shielding can 325 is fixed to the FCP 220. In one implementation, the first shielding can 325 may be soldered to the FCP 220 using a reflow process. Reflow soldering is a process in which a solder paste is used to temporarily attach one or several electrical components to their contact pads, after which the entire assembly is subjected to controlled heat. The controlled heat melts the solder and when the solder cools, a connection is established, in this case, between the first shielding can 325 and the FCP 220.

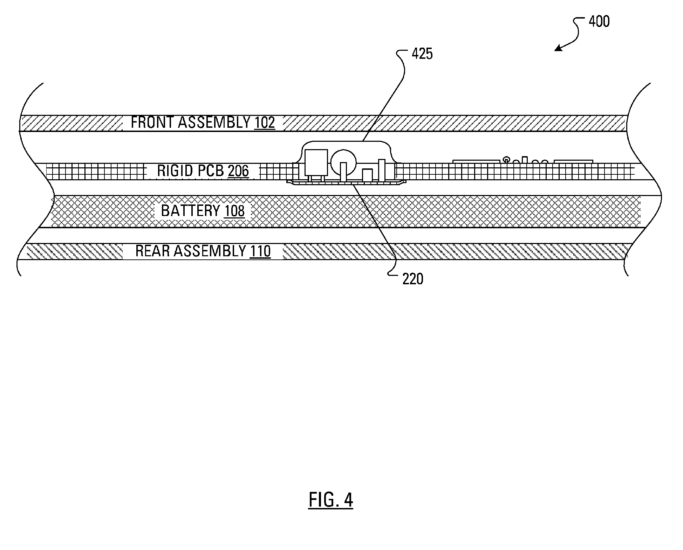

FIG. 4 illustrates another implementation, referenced as a fourth generic electronic device 400, wherein a second shielding can 425 has been added to the electronic device 400 in a manner such that the second shielding can 425 is fixed (e.g., using a reflow soldering process) to the adapted PCB 206. Notably, in the case wherein the second shielding can 425 is fixed to the adapted PCB 206, EMI may bypass the second shielding can 425 unless the wall of the aperture 230 is metalized.

Neither implementation of the shielding can 325, 425 need alter the depth of the gap 204.

In one implementation, manufacturing the fourth generic electronic device 400 includes soldering the high profile components 114 to the FPC 220, soldering the second shielding can 425 to the adapted PCB 206 and using a "hot bar" soldering process to solder the FPC 220 to the adapted PCB 206. Alternatively, an anisotropic conductive film (ACF) bonding process may be used to attach the FPC 220 to the adapted PCB 206.

As a person of ordinary skill in the art is aware, hot bar soldering takes place in a contained system that looks something like a press. The material that will be soldered is placed below the hot bar solder. The system uses a method called pulse bonding. Instead of melting the solder and dripping the solder onto the materials to be soldered together, the two elements to be connected are separately coated with a layer of solder. The elements are pressed together so that the elements are touching, and then a thermode (not shown, a device that delivers a great deal of heat) is pressed against the elements. The elements heat up, the solder on the elements melts and the elements are allowed to cool, while being held together (see www.ehow.com).

To assist in aligning the FPC 220 to the adapted PCB 206 before soldering, the FPC 220 may be provided with a plurality (e.g., four) of FPC alignment apertures. Two FPC alignment apertures 222A, 222B are illustrated in FIG. 2. Similarly, the adapted PCB 206 may be provided with a plurality (e.g., four) of PCB alignment apertures corresponding to the FPC alignment apertures 222A, 222B. Two PCB alignment apertures 232A, 232B are illustrated in FIG. 2.

During assembly, the FPC 220 and the adapted PCB 206 may be placed into a fixture (not shown) having alignment pins. A first pin on the fixture may be received in a first one of the FPC alignment apertures 222A and a first one of the PCB alignment apertures 232A. A second pin on the fixture may be received in a second one of the FPC alignment apertures 222B and a second one of the PCB alignment apertures 232B. Two pins may be considered as providing "good" alignment, where one pin establishes an X-Y location and the other pin establishes an angular position where the first pin is considered a pivot point.

Additionally, the FPC 220 may be arranged to have pre-designed solder traces (not shown) and the adapted PCB 206 may be arranged to have pre-designed solder traces (not shown). Accordingly, after connection of the FPC 220 to the adapted PCB 206, correct predetermined electrical connections for conductive communication may be established between the high profile components 114 and components on the adapted PCB 206.

The above-described implementations of the present application are intended to be examples only. Alterations, modifications and variations may be effected to the particular implementations by those skilled in the art without departing from the scope of the application, which is defined by the claims appended hereto.

## Claims

1. An apparatus (200) comprising:
a first printed circuit (206) defining an aperture (230) and configured for conductive communication between a first plurality of electronic components (112); and
a second printed circuit (220) configured for conductive communication between a second plurality of electronic components (114), said second printed circuit fixed to said first printed circuit such that:
said second plurality of electronic components (114) pass through said aperture (230); and
said second plurality of electronic components (114) are in conductive communication with said first plurality of electronic components (112).

2. The apparatus of claim 1 wherein said second printed circuit defines a first plurality of alignment apertures and said first printed circuit defines a second plurality of alignment apertures corresponding to said first plurality of alignment apertures.

3. The apparatus of claim 1 or claim 2 further comprising a shielding can positioned to enclose said second plurality of electronic components.

4. The apparatus of claim 3 wherein said shielding can is fixed to said second printed circuit or said shielding can is fixed to said first printed circuit.

5. The apparatus of any one of claims 1 to 4 wherein said first printed circuit comprises a rigid printed circuit board.

6. The apparatus of any one of claims 1 to 5 wherein said second printed circuit comprises a flexible printed circuit.

7. A method of manufacturing an apparatus, said method comprising:
forming an aperture (230) in a first printed circuit (206) configured for conductive communication between a first plurality of electronic components (112); and
fixing a second printed circuit (220) to said first printed circuit (206), said second printed circuit (220) configured for conductive communication between a second plurality of electronic components (114) such that:
said second plurality of electronic components (114) pass through said aperture (230); and
said second plurality of electronic components (114) are in conductive communication with said first plurality of electronic components (112).

8. The method of claim 7 further comprising:
forming a first plurality of alignment apertures (222A, 222B) in said second printed circuit (220); and
forming a second plurality of alignment apertures (232A, 232B) in said first printed circuit (206), said second plurality of alignment apertures (232A, 232B) corresponding to said first plurality of alignment apertures (222A, 222B).

9. The method of claim 8 wherein said fixing said second printed circuit to said first printed circuit further comprises aligning said second plurality of alignment apertures with corresponding ones of said first plurality of alignment apertures.

10. The method of any one of claims 7 to 9 wherein said fixing said second printed circuit to said first printed circuit further comprises hot bar soldering said second printed circuit to said first printed circuit.

11. The method of any one of claims 7 to 10 further comprising positioning a shielding can to enclose said second plurality of electronic components.

12. The method of claim 11 further comprising fixing said shielding can to said second printed circuit or fixing said shielding can to said first printed circuit.

13. The method of any one of claims 7 to 12 wherein said first printed circuit comprises a rigid printed circuit board.

14. The method of any one of claims 7 to 13 wherein said second printed circuit comprises a flexible printed circuit.

## Amended claims

### Amended claims in accordance with Rule 137(2) EPC.

**1.** An apparatus (200) comprising:
a first printed circuit (206) defining an aperture (230) and configured for conductive communication between a first plurality of electronic components (112);
a second printed circuit (220) configured for conductive communication between a second plurality of electronic components (114), said second printed circuit fixed to said first printed circuit such that:
said second plurality of electronic components (114) pass through said aperture (230); and
said second plurality of electronic components (114) are in conductive communication with said first plurality of electronic components (112); and
a shielding can fixed to said second printed circuit and positioned to enclose said second plurality of electronic components to reduce electromagnetic interference.

**2.** The apparatus of claim 1 wherein said second printed circuit defines a first plurality of alignment apertures and said first printed circuit defines a second plurality of alignment apertures corresponding to said first plurality of alignment apertures.

**3.** The apparatus of any one of claims 1 to 2 wherein said first printed circuit comprises a rigid printed circuit board.

**4.** The apparatus of any one of claims 1 to 2 wherein said second printed circuit comprises a flexible printed circuit.

**5.** A method of manufacturing an apparatus, said method comprising:
forming an aperture (230) in a first printed circuit (206) configured for conductive communication between a first plurality of electronic components (112); and
fixing a second printed circuit (220) to said first printed circuit (206), said second printed circuit (220) configured for conductive communication between a second plurality of electronic components (114) such that:
said second plurality of electronic components (114) pass through said aperture (230); and
said second plurality of electronic components (114) are in conductive communication with said first plurality of electronic components (112); and
fixing a shielding can to said second printed circuit and in a position to enclose said second plurality of electronic components to reduce electromagnetic interference.

**6.** The method of claim 5 further comprising:
forming a first plurality of alignment apertures (222A, 222B) in said second printed circuit (220); and
forming a second plurality of alignment apertures (232A, 232B) in said first printed circuit (206), said second plurality of alignment apertures (232A, 232B) corresponding to said first plurality of alignment apertures (222A, 222B).

**7.** The method of claim 6 wherein said fixing said second printed circuit to said first printed circuit further comprises aligning said second plurality of alignment apertures with corresponding ones of said first plurality of alignment apertures.

**8.** The method of any one of claims 5 to 7 wherein said fixing said second printed circuit to said first printed circuit further comprises hot bar soldering said second printed circuit to said first printed circuit.

**9.** The method of any one of claims 5 to 8 wherein said first printed circuit comprises a rigid printed circuit board.

**10.** The method of any one of claims 5 to 8 wherein said second printed circuit comprises a flexible printed circuit.
